# EUROPÄISCHE PATENTANMELDUNG

(11) **EP 4 393 708 A1**
(43) Veröffentlichungstag der Anmeldung: **03.07.2024**
(21) Anmeldenummer: 22217172.0
(22) Anmeldetag: 29.12.2022
(51) Int. Cl.: B41F 15/08, B41F 15/36, H05K 3/12

(54) **DRUCKWERKZEUG UND DRUCKVORRICHTUNG ZUM AUFBRINGEN EINES DRUCKMEDIUMMUSTERS AUF EIN SUBSTRAT SOWIE VERWENDUNG EINER DRUCKVORRICHTUNG ZUR AUSBILDUNG METALLISCHER LEITERBAHNEN**

(71) Anmelder: Christian Koenen GmbH, 85521 Ottobrunn-Riemerling (DE)
(72) Erfinder: BECHMANN, Sebastian, 82538 Geretsried (DE)
(74) Vertreter: LBP Lemcke, Brommer & Partner Patentanwälte mbB

(57) **Zusammenfassung**

Die Erfindung betrifft ein Druckwerkzeug zum Aufbringen eines Druckmediummusters auf ein Substrat. Das Druckwerkzeug weist einen Rahmen und eine an dem Rahmen angeordnete Trägerstruktur und eine Druckschablone auf. Die Druckschablone weist hierbei zumindest eine Ausnehmung zum Ausbilden eines Druckmediummusters auf ein Substrat auf. Weiter weist das Druckwerkzeug einen Schablonenhalter und eine Trägerstruktur auf, die zumindest eine Ausnehmung des Druckwerkzeugs in der Druckschablone ausbildet. Die Druckschablone ist dabei an dem Schablonenhalter angeordnet und der Schablonenhalter mittels der Trägerstruktur unter Ausbildung einer Zugspannung an dem Rahmen. Die Trägerstruktur ist zumindest die Ausnehmung der Druckschablone aussparend ausgebildet. Zudem betrifft die Erfindung eine Druckvorrichtung zum Aufbringen eines Druckmediummusters auf ein Substrat sowie die Verwendung einer Druckvorrichtung zur Ausbildung metallischer Leiterbahnen.

## Beschreibung

Die Erfindung betrifft ein Druckwerkzeug gemäß Anspruch 1, eine Druckvorrichtung zum Aufbringen eines Druckmediummusters auf ein Substrat gemäß Anspruch 14, sowie die Verwendung einer Druckvorrichtung gemäß Anspruch 15.

Zum Aufbringen von Druckmedium auf ein Substrat sind das Siebdruckverfahren und das Schablonendruckverfahren bekannt. Die Druckverfahren ermöglicht das Auftragen eines Druckmediums mittels einer Rakel oder eines Rakelsystems.

Typischerweise werden Siebdruckwerkzeuge verwendet, welche ein Siebdruckgewebe mit einer Vielzahl von Gewebeelementen aufweisen. Das Siebdruckgewebe ist hierbei für das Druckmedium durchlässig ausgebildet. An dem Siebdruckgewebe ist ein Negativ des Druckbildes angeordnet. Dieses Negativ des Druckbildes weist Öffnungen auf, sodass das Druckmedium nur im Bereich der Öffnungen hindurchtritt und somit eine durch die Öffnungen der Druckschablone vorgegebene Struktur in Form des Druckbildes aus Druckmedium auf dem Substrat aufgebracht werden kann. Somit ist es in einer einfachen Weise möglich, eine Strukturierung des Druckmediums auf dem Substrat zu erzielen.

Typischerweise werden Schablonendruckwerkzeuge verwendet, welche aus Kunststoffen und oder Metallen bestehen. Eine Schablone des Schablonendruckwerkzeugs weist zu dem Negativ des Druckbildes korrespondierende Öffnungen auf, sodass das Druckmedium nur im Bereich der Öffnungen hindurchtritt und somit eine durch die Öffnungen der Druckschablone vorgegebene Struktur in Form des Druckbildes aus Druckmedium auf dem Substrat aufgebracht werden kann. Somit ist es in einer einfachen Weise möglich, eine Strukturierung des Druckmediums auf dem Substrat zu erzielen

Besonders im Bereich der Halbleitertechnologie, insbesondere bei photovoltaischen Solarzellen, ist es wünschenswert, die Strukturierung des Druckmediums möglichst filigran auszuführen. Es besteht die Anforderung, beim Materialauftrag Schwankungen in der Querschnittsfläche der Strukturen zu vermeiden, da eine sich verringernde Querschnittsfläche aufgrund eines erhöhten Leitungswiderstandes Effizienzverluste zur Folge hat. Weiter bestehen Anforderungen an die genaue Positionierung der aufzutragenden Druckmediumschicht, da bei der voranschreitenden Miniaturisierung der Bauelemente und Platinen die Fehlpositionierungstoleranz zunehmend geringer wird.

Um diesen Anforderungen gerecht zu werden, finden Druckwerkzeuge Anwendung, deren Schablonen eine geringe Dicke aufweisen. Insbesondere ermöglichen Druckschablonen aus Glas im Prinzip eine genaue Definition von feinen Linienstrukturen aus Druckmedium.

Problematisch bei der Verwendung von Druckwerkzeugen mit dünnen Schablonen, insbesondere Glasschablonen, ist das Handling der Schablone innerhalb des Druckwerkzeugs. Dies ist durch die punktuelle Belastung der Druckschablone, welche durch Krafteinwirkung in herkömmlichen Druckwerkzeugen zustande kommt, begründet. Diese Krafteinwirkung entsteht durch Rakeldruck und Rakelreibung. Weitere Krafteinwirkungen besteht durch thermische Einflüsse, sowie durch Biegung und Verwindungen des Rahmens eines Druckwerkzeuges. Hohe Kräfte, welche auf die Schablone wirken, führen zur Verformung der Schablone und können auch zum Bruch der Schablone führen. Die Verformung der Schablone kann zu einem fehlerhaften Auftragen des Druckmediums auf das zu bedruckende Substrat führen.

Durch die Begrenzung der Zugkraft in Anbetracht der maximal zulässigen Zugspannung, welche an der Schablone wirken kann, erreichen Systeme des Standes der Technik nicht die geforderte Spannung, welche zu einer mangelnden Positionsstabilität während der Rakelbewegung führt. Eine Erhöhung der Spannung führt zu einer Erhöhung der Bruchgefahr und somit Verringerung der Lebensdauer des Druckwerkzeugs.

Der vorliegenden Erfindung liegt daher die Aufgabe zugrunde, Strukturen aus Druckmedium auf ein Substrat über eine Druckschablone, insbesondere über Druckschablonen aus sprödem und oder fragilem Material, auszubilden und andererseits eine ausreichende Zugkraft auf die Schablone zur Verfügung zu stellen, ohne die Druckschablone zu verformen oder zu zerbrechen. Weiterhin liegt die Aufgabe zugrunde, im Fertigungsbetrieb einen hohen Durchsatz und dennoch eine lange Haltbarkeit und somit Nutzungsdauer des Druckwerkzeugs zu ermöglichen.

Gelöst wird diese Aufgabe durch ein Druckwerkzeug gemäß Anspruch 1 sowie durch eine Druckvorrichtung gemäß Anspruch 14, sowie die Verwendung einer Druckvorrichtung gemäß Anspruch 15. Vorzugsweise Ausgestaltungen des erfindungsgemäßen Druckwerkzeugs finden sich in den Ansprüchen 2 bis 13. Hiermit wird der Wortlaut sämtlicher Ansprüche explizit per Referenz in die Beschreibung einbezogen.

Das erfindungsgemäße Druckwerkzeug weist einen Rahmen und eine an den Rahmen angeordnete Trägerstruktur und eine Druckschablone auf. Die Druckschablone weist zumindest eine Ausnehmung zum Ausbilden eines Druckmediummusters auf einem Substrat auf.

Wesentlich ist, dass das Druckwerkzeug einen Schablonenhalter und eine Trägerstruktur aufweist. Weiter ist wesentlich, dass die Druckschablone an dem Schablonenhalter angeordnet ist und der Schablonenhalter mittels der Trägerstruktur unter Ausbildung einer Zugspannung an dem Rahmen angeordnet ist. Weiterhin ist wesentlich, dass die Trägerstruktur zumindest die Ausnehmungen der Druckschablone aussparend ausgebildet ist.

Hierdurch ergeben sich die Vorteile, dass es bedingt durch die Entkopplung der Trägerstruktur von der Schablone über den Schablonenhalter, zu keiner direkten Kraftübertragung zwischen Trägerstruktur und Schablone kommt. Es wird somit vermieden, dass es zu punktuellen Zugbelastungen an der Schablone kommt. Solche punktuellen Zugbelastungen führen zu in das Material der Schablone eingetragenen Kraftspitzen, welche zu Mikrorissen und im schlimmsten Fall zum Bruch der Schablone führen.

Ein weiterer Vorteil des erfindungsgemäßen Druckwerkzeuges beruht darauf, dass die Trägerstruktur zumindest die Ausnehmung der Druckschablone aussparend ausgebildet ist, sodass keine Trägerstruktur im Bereich der Ausnehmungen vorliegt. Somit ist der ausgesparte Teil der Druckschablone frei von Trägermaterial. Vorteilhaft ist zudem, dass der Schablonenhalter im eingespannten Zustand die Spannungen der Druckschablone sowie die beim Rakelprozess auftretenden Scherkräfte aufnimmt. Durch den Schablonenhalter werden die auftretenden Kräfte aufgenommen oder zumindest derart abgeschwächt, so dass eine Beschädigung der Druckschablone oder eine Verzerrung der aufzubringenden Struktur in einer vorteilhaften Weise verhindert wird. Die auf den Schablonenhalter wirkenden Kräfte, welche beim Rakelprozess auftreten, werden im eingespannten Zustand über die Trägerstruktur durch den Rahmen aufgenommen. Somit wird vorteilhaft eine gleichbleibende Positionierung der Druckschablone erzielt.

In einer bevorzugten Ausführungsform weist der Schablonenhalter des Druckwerkzeugs zumindest eine vollständig umschlossene Ausnehmung auf. Weiter ist die Ausnehmung der Druckschablone innerhalb der Ausnehmung des Schablonenhalters angeordnet.

Vorteilhaft ist bei dieser Ausführungsform, dass durch die Anordnung der Druckschablone innerhalb der Ausnehmung des Schablonenhalters ein Bereich zustande kommt, welcher frei zugänglich für das aufzubringende Druckmedium ist, damit dieses ungehindert durch die Ausnehmung auf das Substrat aufgebracht werden kann. Durch diese freie Zugänglichkeit wird zudem eine ausreichende Zufuhr von Druckmedium während des Rakelprozesses ermöglicht.

Ein weiterer Vorteil ist, dass durch die umlaufende umschlossene Ausnehmung eine vollständig umschlossene Anordnung des Schablonenhalters und somit besondere Stabilität ermöglicht wird. Diese vollständig umschlossene Anordnung ermöglicht es, die Druckschablone mit gleichbleibender Zugkraft an dem Schablonenhalter anzuordnen. Hierdurch wird ein Brechen der Druckschablone bedingt durch punktuelle Zuglastspitzen unterbunden.

In einer bevorzugten Ausführungsform ist der Schablonenhalter als Schablonenrahmen ausgebildet und überlappt umlaufend mit dem Rand der Druckschablone.

Vorteilhaft ist hierbei, dass durch die Ausführung des Schablonenhalters als Schablonenrahmen und der umlaufenden Überlappung der Druckschablone ein Überlappungsbereich entsteht, der zu einem größeren Anbindungsbereich führt. Der Anbindungsbereich ermöglicht es, Kräfte großflächig zu übertragen. Weiter ist dies vorteilhaft, da durch die Überlappung das Fügen der Elemente bei der Fertigung des Druckwerkzeugs in einer einfachen Art und Weise durchgeführt werden kann.

In einer weiteren vorzugsweisen Ausführungsform ist die Druckschablone in einem Überlappungsbereich mit dem Schablonenhalter umlaufend stoffschlüssig mit dem Schablonenhalter verbunden.

Vorteilhaft ist hier, dass durch die Ausführungen des Schablonenhalters als Schablonenrahmen und der umlaufenden Überlappung der Druckschablone ein Überlappungsbereich entsteht, der zu einer besseren Anbindung führt. Um die Kräfte, insbesondere die auftretenden Zugkräfte sowie Scherkräfte, gleichmäßig zu übertragen.

In einer weiteren vorzugsweisen Ausführungsform des Druckwerkzeuges überlappt die Trägerstruktur mit dem Rahmen des Druckwerkzeugs, insbesondere überlappt die Trägerstruktur mit dem Rahmen des Druckwerkzeugs umlaufend.

Vorteilhaft ist bei dieser Ausführungsform des Druckwerkzeuges, dass durch die Überlappung der Trägerstruktur mit dem Rahmen des Druckwerkzeuges ein Überlappungsbereich entsteht, der zu einer besseren Anbindung führt, um Kräfte zu übertragen. Weiterhin ist es bei dieser Ausführungsform vorteilhaft, dass insbesondere im umlaufenden Falle der Überlappung eine Gleichverteilung der aufgebrachten Zugkräfte zustande kommt.

In einer weiteren vorzugsweisen vorteilhaften Ausführungsform des Druckwerkzeuges ist die Trägerstruktur die Druckschablone aussparend ausgebildet.

Bei herkömmlichen Druckwerkzeugen ist die Druckschablone auf einem durchgängigen Trägermaterial angeordnet, welches somit auch die Ausnehmungen der Druckschablone überdeckt. Dieses Trägermaterial ist typischerweise netzartig ausgebildet und weist eine Maschenweite auf. Nachteilig ist hierbei, insbesondere bei Verwendung von sogenannten Siebgeweben als Trägermaterial, dass bei sehr kleinen Strukturen, welche auf ein Substrat aufgebracht werden sollen, ein Trägermaterial verwendet werden muss, das Drähte mit einem Durchmesser aufweist, welche im Wesentlichen kleiner sind als die zu druckenden Strukturen. Diese Trägermaterialien führen zu einer geringeren Stabilität und einer schlechten Maßhaltigkeit der Druckschablone. Die beschriebenen Nachteile werden durch ein Aussparen der Trägerstruktur im Bereich der Druckschablone unterbunden. Vorteilhaft ist zudem, dass somit die Möglichkeit der Verwendung von nichtdurchlässigen Trägermaterialien ermöglicht wird, insbesondere Trägermaterialien aus formfesten, aber elastisch verformbaren Kunststoffen.

In einer bevorzugten Ausführungsform des Druckwerkzeuges ist zwischen der Druckschablone und der Trägerstruktur keine unmittelbare, stoffschlüssige Verbindung ausgebildet.

Vorteilhaft ist hierbei, dass durch eine lediglich mittelbare Verbindung der Druckschablone, insbesondere über den Schablonenträger, verhindert wird, dass es zu einer punktuellen Zugbelastung der Druckschablone durch eine Verbindung mit dem Trägermaterial kommt. Diese punktuelle Belastung führt zu lokalen Spannungsrissen, die das Risiko eines Schablonenbruchs erhöhen.

In einer weiteren vorteilhaften Ausführungsform des Druckwerkzeuges sind die Druckschablone und die Trägerstruktur an gegenüberliegenden Seiten des Schablonenhalters angeordnet.

Vorteilhaft ist bei dieser Ausführungsform, dass somit eine Verbesserung des Druckbildes erzielt wird. Diese Verbesserung des Druckbildes wird insbesondere erzielt, wenn die Dicke der Trägerstruktur größer ist als die der Druckschablone.

In einer weiteren vorzugsweisen Ausführungsform des Druckwerkzeuges sind die Druckschablone und die Trägerstruktur an derselben Seite des Schablonenhalters angeordnet, wobei bevorzugt Druckschablone und Trägerstruktur nicht überlappen.

Vorteilhaft ist bei dieser Ausführungsform, dass bedingt durch die auf der gleichen Seite liegenden Überlappungsbereiche in einfacher Art und Weise ein einseitig durchgeführtes Fügeverfahren für beide Überlappungsbereiche im Rahmen der Produktion getätigt werden kann.

In einer weiteren vorzugsweisen Ausführungsform ist die Trägerstruktur stoffschlüssig mit dem Schablonenhalter und der Schablonenhalter stoffschlüssig mit der Druckschablone verbunden und insbesondere stoffschlüssig verbunden durch eines der Verfahren Kleben, Löten, Schweißen oder Vulkanisieren.

Durch die stoffschlüssige Verbindung, insbesondere durch eines der Verfahren Kleben, Löten, Schweißen oder Vulkanisieren wird eine hohe maximale Zugfestigkeit erreicht. Die Übertragungsfähigkeit von Kräften und Momenten wird über die stoffschlüssige Verbindung verbessert. Ein weiterer Vorteil der stoffschlüssigen Verbindung ist, dass für eine stoffschlüssige Verbindung keinen zusätzlichen Bauraum benötigt, wie es beispielsweise bei Ausführungsformen mit kraftschlüssigen Verbindungen wie beispielsweise Klemmen der Fall ist.

In einer bevorzugten Ausführungsform des Druckwerkzeuges ist die Trägerstruktur aus einem biegeschlaffen Material ausgebildet, insbesondere als Gewebe ausgebildet, insbesondere bevorzugt als ein Gewebe aus Kunststofffäden.

Vorteilhaft ist bei dieser Ausführungsform, dass durch die biegeschlaffe Eigenschaft der Trägerstruktur Zugkräfte übertragen werden können. Zudem ist es von Vorteil, dass durch die Ausführung der Trägerstruktur aus biegeschlaffen Materialien eine gewünschte Elastizität erreicht wird, welche es ermöglicht, die Druckschablone auf leicht unebenen Oberflächen zu positionieren. Dies ist insbesondere der Fall, wenn sich auf der Oberfläche schon Leiterbahnen oder andere Bauelemente befinden.

In einer weiteren bevorzugten Ausführungsform des Druckwerkzeuges ist die Druckschablone aus einem formstabilen Material ausgebildet, insbesondere aus Glas, Edelstahl, Aluminium oder Kunststoff ausgebildet. Besonders vorteilhaft ist die Ausbildung der Druckschablone aus Glas.

Die Vorteile bei der Verwendung der genannten Materialien, insbesondere der Verwendung von Glas, im Gegensatz zu herkömmlichen Materialien, sind darin begründet, dass Glas eine erhöhte Kratzfestigkeit aufweist. Zudem weist Glas ein hohes Elastizitätsmodul auf und zudem eine geringe thermische Ausdehnung. Weiter ist es von Vorteil, dass die Materialien eine hohe Abriebfestigkeit sowie chemische Beständigkeit aufweisen. Ein weiterer Vorteil der formstabilen Materialien ist, dass diese ein sehr präzises Druckbild ermöglichen und dass sie bedingt durch die Formstabilität nur unwesentlichen prozessbedingten Verzugserscheinungen unterliegen.

In einer weiteren vorzugsweisen Ausführungsform ist der Schablonenhalter nicht biegeschlaff ausgebildet, insbesondere ist der Schablonenhalter bevorzugt aus einem formstabilen Material ausgebildet, bevorzugt aus Edelstahl, Aluminium oder Kunststoff ausgebildet.

Die formstabile Ausgestaltung ist vorteilhaft, da hierdurch eine Kräfteaufnahme der Zugspannung der Trägerstruktur ermöglicht wird, ohne dass diese Zugspannung auf die Druckschablone übertragen wird.

Die Vorteile bei der Verwendung der genannten Materialien sind darin begründet, dass diese eine erhöhte Kratzfestigkeit aufweisen. Weiter ist es von Vorteil, dass die Materialien eine hohe Abriebfestigkeit sowie chemische Beständigkeit aufweisen. Ein weiterer Vorteil der formstabilen Materialien ist, dass sie bedingt durch die Formstabilität nur unwesentlichen prozessbedingten Verzugserscheinungen unterliegen.

In einer bevorzugten Ausführungsform des Druckwerkzeuges sind die Druckschablone und der Schablonenhalter aus unterschiedlichen Materialien ausgebildet, insbesondere ist die Druckschablone bevorzugt aus Glas ausgebildet und der Schablonenhalter nicht aus Glas ausgebildet.

Die Vorteile bei der Verwendung von sich unterscheidenden Materialien ist begründet in der Möglichkeit, Materialkombination zu nutzen, um ergänzende Funktionen in das Druckwerkzeug zu integrieren, somit wird die Druckschablone über den Schablonenhalter funktionssicher montierbar, wenn der Schablonenhalter beispielsweise aus Edelstahl und die Druckschablone aus Glas gefertigt ist. Dies führt zu einer Verringerung der Montageumfänge sowie die zusätzlichen Nacharbeiten und senkt Qualitätssicherungskosten.

In einer vorzugsweisen Ausführungsform des Druckwerkzeuges weisen die Druckschablone und der Schablonenhalter eine unterschiedliche Dicke auf. Es ist vorteilhaft, dass die Druckschablone eine geringere Dicke als der Schablonenhalter aufweist, insbesondere, dass die Druckschablone eine um zumindest 50 µm, bevorzugt um zumindest 250 µm, insbesondere zumindest 500 µm geringere Dicke aufweist als die Dicke des Schablonenhalters.

Eine dünne Druckschablone ermöglicht eine präzise Definition von Druckmustern mit feinen Linien. Ein demgegenüber dickerer Schablonenhalter führ zu einer besseren Stabilität gegenüber der Zugspannung der Trägerstruktur.

Vorteilhafterweise weist die Druckschablone eine Dicke kleiner 1000 µm, insbesondere eine Dicke kleiner 500 µm, bevorzugt eine Dicke kleiner 200 µm auf. Vorteilhafterweise weist der Schablonenhalter eine Dicke größer 1000 µm, insbesondere eine Dicke größer 2 mm auf.

In einer bevorzugten Ausführungsform des Druckwerkzeuges ist die Druckschablone einstückig ausgebildet.

Vorteilhaft bei einer Ausführungsform des Druckwerkzeuges mit einstückig ausgebildeter Druckschablone ist, dass es somit nicht zu punktuellen Zugbelastungen an der Druckschablone kommt, somit werden Mikrorisse und ein Druckschablonenbruch vermieden. Ein weiterer Vorteil ist die zunehmende Stabilität der Druckschablone.

Die zuvor beschriebene Aufgabe ist weiterhin gelöst durch eine Druckvorrichtung zum Aufbringen eines Druckmediummusters auf ein Substrat.

Die erfindungsgemäße Druckvorrichtung wird vorzugsweise unter Einsatz des oben beschriebenen erfindungsgemäßen Druckwerkzeugs bzw. bevorzugt einer vorzugsweisen Ausführungsform des erfindungsgemäßen Druckwerkzeuges ausgebildet.

Vorteilhaft ist hierbei, dass durch den Aufbau des Druckwerkzeugs ein niveauausgleichendes Druckverhalten durch die biegeschlaffe Trägerstruktur mit einer genauen Positionierung des Druckmediums durch die formstabile Druckschablone vereint wird. Die Druckvorrichtung umfasst zumindest ein erfindungsgemä-βes Druckwerkzeug und zumindest eine Rakel. Die Druckvorrichtung ist ausgebildet, um mittels der Rakel ein Druckmedium durch zumindest eine Ausnehmung der Druckschablone auf das Substrat aufzubringen.

Es liegt im Rahmen der Erfindung, dass die Druckvorrichtung konstruktiv in an sich bekannter Weise ausgebildet ist. Weiterhin liegt es im Rahmen der Erfindung eine an sich bekannte Bewegungseinheit zum Bewegen der Rakel sowie eine Zuführeinheit zum Zuführen von Druckmedium konstruktiv in an sich bekannter Weise auszubilden.

Die eingangs genannte Aufgabe ist weiterhin durch eine erfindungsgemäße Verwendung einer erfindungsgemäßen Druckvorrichtung zur Ausbildung einer metallischen Struktur eines Halbleiterbauelements, insbesondere zur Ausbildung einer metallischen Kontaktierungsstruktur einer Solarzelle, gelöst.

Vorteilhaft ist, dass die Verwendung der erfindungsgemäßen Druckvorrichtung zu einer zeit- und kosteneffizienten Fertigung beiträgt. Weiterhin ist vorteilhaft, dass die Fertigungstoleranzen bei der Verwendung der Druckvorrichtung in einem engeren Maß eingehalten werden können. Weiterhin ist die Verwendung einer erfindungsgemäßen Druckvorrichtung von Vorteil, da bedingt durch die Langlebigkeit des Druckwerkzeuges ein geringerer Wartungsaufwand, insbesondere durch vorbeugen von Bruch und Mikrorissen der Druckschablone. Ein weiterer Vorteil bei der Verwendung der erfindungsgemäßen Druckvorrichtung ist, dass durch die geringere Ausfallwahrscheinlichkeit des erfindungsgemäßen Druckwerkzeuges es zu weniger ausfallbedingten Druckwerkzeugwechseln innerhalb der Produktion kommt.

Es liegt zudem im Rahmen der Erfindung, eine oder mehrere Ausnehmungen mit größerer Breite vorzusehen, um mittels einer Mehrzahl an Ausnehmungen der Druckschablone Kontaktfinger zur Verbindung von sogenannten Verbindern mit einem Busbar zu ermöglichen. Insbesondere liegt es im Rahmen der Erfindung, die Ausnehmungen für an sich bekannte metallische Kontaktierungsstrukturen für Solarzellen auszubilden, insbesondere für Strukturen mit mehreren parallel verlaufenden Kontaktierungsfingern und einem oder mehreren senkrecht zu den Kontaktierungsfingern verlaufenden Busbars.

Das erfindungsgemäße Druckwerkzeug und die Druckvorrichtung sind grundsätzlich für Anwendungen in den Bereichen der Mikroelektronikmetallisierung, Solarzellenmetallisierung sowie dem Druck von LED/OLED, LTCC und auf Halbleiterwafern geeignet.

Es liegt im Rahmen der Erfindung den Rahmen, die Druckschablone sowie den Schablonenhalter in sich geometrisch unterscheidenden Grundformen auszuführen.

Weiter liegt es im Rahmen der Erfindung, die Druckschablone auswechselbar an dem Schablonenhalter und/oder den Schablonenhalter auswechselbar an der Trägerstruktur anzuordnen. Vorteilhaft ist hierbei die einfache Umrüstung der Druckschablone innerhalb des Druckwerkzeuges.

In alternativen Ausgestaltungen können die Elemente auch anders oder durch Kombination von Befestigungsarten befestigt werden. Besonders bevorzugt ist jedoch die stoffschlüssige Anordnung der Druckschablone an dem Schablonenhalter und die stoffschlüssige Anordnung der Trägerstruktur an dem Schablonenhalter.

Weitere bevorzugte Merkmale und Ausführungsformen des erfindungsgemäßen Druckwerkzeuges und der erfindungsgemäßen Druckvorrichtung werden im Folgenden anhand von Ausführungsbeispielen und den Figuren erläutert. Die Ausführungsbeispiele sind lediglich vorteilhafte Ausgestaltungen der Erfindung und nicht einschränkend. Es zeigt:
- Fig. 1: eine schematische Darstellung eines ersten Ausführungsbeispiels eines Druckwerkzeuges in Frontansicht (1a) und in Schnittansicht (1b),
- Fig. 2: eine schematische Darstellung eines zweiten Ausführungsbeispiels eines Druckwerkzeuges in Frontansicht (2a) und in Schnittansicht (2b) und
- Fig. 3: eine schematische Schnittdarstellung eines Ausführungsbeispiels einer erfindungsgemäßen Druckvorrichtung.

Die Figuren zeigen schematische, nicht maßstabsgetreue Darstellungen. Gleiche Bezugszeichen in den Figuren bezeichnen gleiche oder gleichwirkende Elemente.

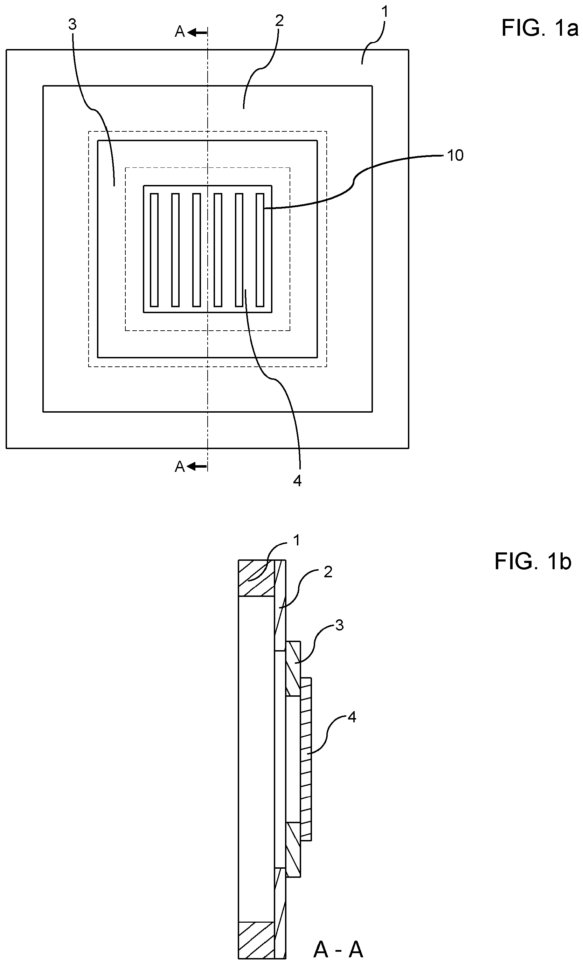

Das in Figur 1a gezeigte Ausführungsbeispiel eines erfindungsgemäßen Druckwerkzeuges ist in einer Frontansicht gezeigt. Das vorliegende Druckwerkzeug weist eine Druckschablone 4 mit sechs linienartigen Ausnehmungen 10 auf. Die Druckschablone 4 weist zudem in diesem Ausführungsbeispiel eine quadratförmige Grundfläche auf. In diesem Beispiel ist die Druckschablone 4 aus einer 20 µm dicken formstabilen Glasplatte gefertigt. Für die Fertigung der Ausnehmungen 10 wird das sogenannte LIDE-Verfahren (Laser Inducted Deep Etching) verwendet. Die Druckschablone 4 ist an einem als formsteifen Schablonenrahmen ausgeführten Schablonenhalter 3 angeordnet. Der Schablonenhalter 3 weist hierbei eine quadratische Ausnehmung 10 auf, welche vollständig von dem Schablonenhalter 3 umschlossen ist. Die Druckschablone 4 überlappt in einem umlaufenden Überlappungsbereich mit dem Schablonenhalter, dieser Überlappungsbereich umschließt die Ausnehmung 10 des Schablonenhalters vollständig. Die Druckschablone 4 ist in dem Überlappungsbereich mit dem Schablonenhalter 3 durch das Fügeverfahren Laserschweißen verbunden. Die Druckschablone 4 ist hierbei unter Zug angeordnet. Die Zugspannung wird gleichmäßig über den Schablonenhalter 3 im Überlappungsbereich an die Druckschablone 4 geführt. Der Schablonenhalter, welcher als Schablonenrahmen ausgeführt ist, ist in diesem Ausführungsbeispiel aus einem 1,5 mm dicken Edelstahlblech gefertigt.

Der Schablonenhalter 3 ist über die Trägerstruktur 2 an dem Rahmen 1 befestigt. Die Trägerstruktur 2 weist eine quadratische Aussparung auf. Die Aussparung der Trägerstruktur reicht bis in den Innenbereich des Schablonenhalters 3, sodass ein Überlappungsbereich entsteht, welcher den Schablonenhalter 3 vollständig umschließt. Die Trägerstruktur ist in diesem Ausführungsbeispiel als ein biegeschlaffes Kunststoffgewebe ausgebildet. Dieses biegeschlaffe Kunststoffgewebe ist im Überlappungsbereich zu dem Schablonenhalter 3 über das Fügeverfahren Kleben stoffschlüssig verbunden. Der Rahmen 1 des Druckwerkzeuges ist in diesem Falle aus einem Edelstahlhohlprofil gefertigt und weist eine formsteife quadratische Rahmenform auf. Die Trägerstruktur 2 ist mit dem Rahmen 1 des Druckwerkzeugs umlaufend überlappt. In diesem umlaufenden Überlappungsbereich ist die Trägerstruktur stoffschlüssig über Kleber mit dem Rahmen 1 verbunden.

Die Druckschablone 4 und die Trägerstruktur sind an gegenüberliegenden Seiten des Schablonenhalters angeordnet. Bei diesem Ausführungsbeispiel ist die Druckschablone 4 beim Auflegen des Druckwerkzeuges auf das Substrat 7 im Druckprozess durch die Druckvorrichtung das erste Element, welches auf dem Substrat 7 aufliegt.

In diesem Ausführungsbeispiel ist die Trägerstruktur 2 unter Zugspannung zwischen dem Rahmen 1 und dem Schablonenhalter 3 angeordnet. Die Trägerstruktur überlappt nicht mit der Druckschablone 4, es besteht auch keine stoffschlüssige unmittelbare Verbindung zwischen der Trägerstruktur 2 und der Druckschablone 4. Die Zugkraft, welche durch die Trägerstruktur auf den Schablonenhalter 3 wirkt, verteilt sich gleichermaßen am Rand des Schablonenhalters. Somit wird der Schablonenhalter 3 an seiner Position gehalten. Der Schablonenhalter 3 entkoppelt die Schablone von der Trägerstruktur und somit schützt der Schablonenhalter 3 die Druckschablone 4 vor Zugspannungsspitzen, welche bedingt durch die Elastizität der Trägerstruktur beim Rakeln entstehen.

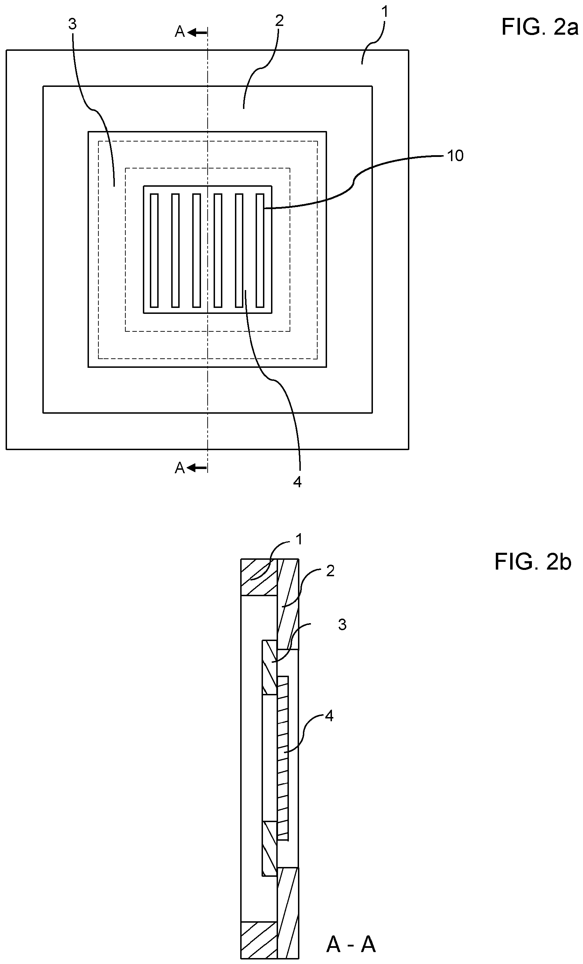

Das in Figur 2 gezeigte Ausführungsbeispiel ist eine abgewandelte Ausführung des Ausführungsbeispiels gemäß Figur 1. Zur Vermeidung von Wiederholungen wird im Folgenden lediglich auf den Unterschied zu dem in Figur 1 gezeigten Ausführungsbeispiel eingegangen:
Das in Figur 2a gezeigte Ausführungsbeispiel eines erfindungsgemäßen Druckwerkzeugs ist in einer Frontansicht gezeigt. In Figur 2b ist eine seitliche Schnittdarstellung gezeigt.

Das in Figur 2 gezeigte Ausführungsbeispiel unterscheidet sich dahingehend von dem Ausführungsbeispiel der Figur 1, dass die Druckschablone 4 und die Trägerstruktur an derselben Seite des Schablonenhalters angeordnet sind. Auch in diesem Ausführungsbeispiel überlappt die Trägerstruktur nicht mit der Druckschablone 4. In diesem Ausführungsbeispiel ist die Trägerstruktur dicker ausgeführt als die Druckschablone 4. Hierbei übernimmt die Trägerstruktur eine Schutzfunktion, da diese zuerst auf dem Substrat 7 während des Druckvorgangs aufkommt. Somit können über die Elastizität der Trägerstruktur Unebenheiten ausgeglichen werden, ohne dass die Druckschablone 4 beschädigt wird. Dies ist beispielsweise der Fall, wenn sich während des Druckvorgangs schon Bauelemente oder Leiterbahnen auf einem Substrat 7 befinden.

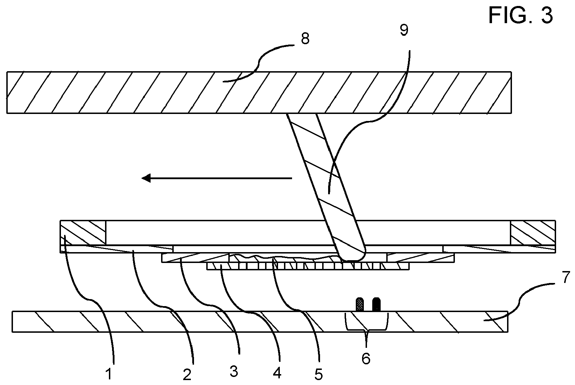

In Figur 3 ist ein Ausführungsbeispiel einer erfindungsgemäßen Druckvorrichtung schematisch dargestellt. Die Druckvorrichtung weist ein erfindungsgemä-βes Druckwerkzeug auf, gemäß dem in Figur 1 gezeigten Ausführungsbeispiel. Die Druckschablone 4 ist im Schablonenhalter 3 angeordnet und über die Trägerstruktur im Rahmen 1 angeordnet. Die Druckschablone 4 weist Ausnehmungen 10 auf, welche nicht von der Trägerstruktur bedeckt sind. Weiter weist die Druckvorrichtung eine Rakel 9 sowie eine Bewegungseinheit 8 auf, an welcher die Rakel 9 befestigt ist. Die Bewegungseinheit 8 sowie der Rahmen 1 des Druckwerkzeugs sind an einem nicht dargestellten Halterungselement der Druckvorrichtung angeordnet, welche ebenfalls eine Auflage für ein Substrat 7 aufweist. In diesem Ausführungsbeispiel stellt das Substrat 7 eine vorläufige noch zu bedruckende Siliziumsolarzelle dar, auf welche metallische Kontaktierungsfinger 6 aufgebracht werden sollen. Mittels einer ebenfalls nicht dargestellten Druckmedium-Zuführeinheit der Druckvorrichtung wird eine Metallpartikel enthaltende Druckpaste 5 auf die dem Substrat abgewandten Seite der Druckschablone 4 aufgebracht. Mittels der Bewegungseinheit 8 wird die Rakel 9 über die Druckschablone 4 bewegt und hierdurch die Druckpaste 5 durch die Ausnehmungen 10 der Druckschablone 4 auf das Substrat 7 gedrückt, sodass auf dem Substrat 7 Druckpaste 5 in Form von Kontaktfingern 10 aufgebracht wird.

Die Figur 3 zeigt eine schematische Darstellung. Bei einer realen Ausbildung erfolgt typischerweise eine leichte Biegung der Trägerstruktur 2 im Bereich zwischen Rahmen 1 und des Schablonenhalters 3. Die durch diese Verformung auftretenden zusätzlichen Zugspannungsspitzen werden vom Schablonenhalter 3 aufgenommen und nicht an die Druckschablone 4 weitergegeben. Beim Passieren der Rakel 9 über die Druckschablone 4 wird diese trotz der formstabilen Eigenschaft leicht in Richtung des Substrates 7 gebogen.

### Bezugszeichenliste

- 1: Rahmen
- 2: Trägerstruktur
- 3: Schablonenhalter
- 4: Druckschablone
- 5: Druckpaste
- 6: Kontaktfinger
- 7: Substrat
- 8: Bewegungseinheit
- 9: Rakel
- 10: Ausnehmung

## Patentansprüche

1. Druckwerkzeug mit einem Rahmen (1) und einer an dem Rahmen (1) angeordneten Trägerstruktur (2) und einer Druckschablone (4), wobei die Druckschablone (4) zumindest eine Ausnehmung (10) zum Ausbilden eines Druckmediummusters auf einem Substrat (7) aufweist,
**dadurch gekennzeichnet,**
**dass** das Druckwerkzeug einen Schablonenhalter (3) und eine Trägerstruktur (2) aufweist,
**dass** die Druckschablone (4) an dem Schablonenhalter (3) angeordnet ist und der Schablonenhalter (3) mittels der Trägerstruktur (2) unter Ausbildung einer Zugspannung an dem Rahmen (1) angeordnet ist und
**dass** die Trägerstruktur (2) zumindest die Ausnehmung (10) der Druckschablone (4) aussparend ausgebildet ist.

2. Druckwerkzeug nach Anspruch 1,
**dadurch gekennzeichnet,**
**dass** der Schablonenhalter (3) zumindest eine vollständig umschlossene Ausnehmung (10) aufweist und die Ausnehmung (10) der Druckschablone (4) innerhalb der Ausnehmung (10) des Schablonenhalters (3) angeordnet ist.

3. Druckwerkzeug nach einem der vorangegangenen Ansprüche,
**dadurch gekennzeichnet,**
**dass** der Schablonenhalter (3) als Schablonenrahmen ausgebildet ist und umlaufend mit dem Rand der Druckschablone (4) überlappt.

4. Druckwerkzeug nach Anspruch 3,
**dadurch gekennzeichnet,**
**dass** die Druckschablone (4) in einem Überlappungsbereich mit dem Schablonenhalter (3) umlaufend stoffschlüssig mit dem Schablonenhalter (3) verbunden ist.

5. Druckwerkzeug nach einem der vorangegangenen Ansprüche,
**dadurch gekennzeichnet,**
**dass** die Trägerstruktur (2) mit dem Rahmen (1) des Druckwerkzeugs überlappt, insbesondere umlaufend überlappt.

6. Druckwerkzeug nach einem der vorangegangenen Ansprüche,
**dadurch gekennzeichnet,**
**dass** die Trägerstruktur (2) die Druckschablone (4) aussparend ausgebildet ist.

7. Druckwerkzeug nach einem der vorangegangenen Ansprüche,
**dadurch gekennzeichnet,**
**dass** zwischen Druckschablone (4) und Trägerstruktur (2) keine unmittelbare, stoffschlüssige Verbindung ausgebildet ist.

8. Druckwerkzeug nach einem der vorangegangenen Ansprüche,
**dadurch gekennzeichnet,**
**dass** Druckschablone (4) und Trägerstruktur (2) an gegenüberliegenden Seiten des Schablonenhalters (3) angeordnet sind.

9. Druckwerkzeug nach einem der vorangegangenen Ansprüche 1 bis 8,
**dadurch gekennzeichnet,**
**dass** Druckschablone (4) und Trägerstruktur (2) an derselben Seite des Schablonenhalters (3) angeordnet sind, wobei bevorzugt Druckschablone (4) und Trägerstruktur (2) nicht überlappen.

10. Druckwerkzeug nach einem der vorangegangenen Ansprüche,
**dadurch gekennzeichnet,**
**dass** die Trägerstruktur (2) stoffschlüssig mit dem Schablonenhalter (3) und der Schablonenhalter (3) stoffschlüssig mit der Druckschablone (4) verbunden ist, insbesondere stoffschlüssig verbunden durch eines der Verfahren Kleben, Löten, Schweißen oder Vulkanisieren.

11. Druckwerkzeug nach einem der vorangegangenen Ansprüche,
**dadurch gekennzeichnet,**
**dass** die Trägerstruktur (2) aus einem biegeschlaffen Material ausgebildet ist, insbesondere als Gewebe ausgebildet ist, insbesondere als ein Gewebe mit Kunststofffäden ausgebildet ist.

12. Druckwerkzeug nach einem der vorangegangenen Ansprüche,
**dadurch gekennzeichnet,**
**dass** die Druckschablone (4) aus einem formstabilen Material ausgebildet ist, insbesondere aus Glas, Edelstahl, Aluminium oder Kunststoff, bevorzugt aus Glas, ausgebildet ist.

13. Druckwerkzeug nach einem der vorangegangenen Ansprüche,
**dadurch gekennzeichnet,**
**dass** Druckschablone (4) und Schablonenhalter (3) aus unterschiedlichen Materialien ausgebildet sind, insbesondere, dass die Druckschablone aus Glas ausgebildet ist und der Schablonenhalter (3) nicht aus Glas ausgebildet ist.

14. Druckvorrichtung zum Aufbringen eines Druckmediummusters auf ein Substrat (7) umfassend ein Druckwerkzeug nach einem der vorangegangenen Ansprüche und zumindest eine Rakel (9), wobei die Druckvorrichtung ausgebildet ist, mittels der Rakel (9) der Druckvorrichtung ein Druckmedium durch zumindest eine Ausnehmung (10) der Druckschablone (4) auf das Substrat (7) aufzubringen.

15. Verwendung eines Druckwerkzeugs nach einem der Ansprüche 1 bis 13 zur Ausbildung einer metallischen Struktur eines Halbleiterbauelements, insbesondere zur Ausbildung einer metallischen Kontaktierungsstruktur einer Solarzelle.
